# EUROPEAN PATENT APPLICATION

(11) **EP 2 061 070 A1**
(43) Date of publication of application: **20.05.2009**
(21) Application number: 07807011.7
(22) Date of filing: 10.09.2007
(51) Int. Cl.: H01L 21/304, B24B 37/00, C09K 3/14

(54) **POLISHING AGENT FOR SEMICONDUCTOR INTEGRATED CIRCUIT DEVICE, POLISHING METHOD, AND METHOD FOR MANUFACTURING SEMICONDUCTOR INTEGRATED CIRCUIT DEVICE**

(30) Priority: 11.09.2006 JP 2006245262
(71) Applicant: Asahi Glass Co., Ltd., Tokyo 100-8405 (JP)
(72) Inventor: KON, Yoshinori, Tokyo 100-8405 (JP); YOSHIDA, Iori, Tokyo 100-8405 (JP); NAKAZAWA, Norihito, Tokyo 100-8405 (JP)
(74) Representative: Müller-Boré & Partner Patentanwälte
(86) International application number: PCT/JP2007/067601
(87) International publication number: WO 2008/032680

(57) **Abstract**

The present invention is to provide a polishing technique ensuring that when polishing a to-be-polished surface in the production of a semiconductor integrated circuit device, appropriate polishing rate ratios can be obtained between a borophosphosilicate glass material layer and other materials and high planarization of the to-be-polished surface containing a borophosphosilicate glass material layer can be thereby realized. The present invention relates to a polishing agent for chemical mechanical polishing, containing a cerium oxide particle, a water-soluble polyamine, one or more basic compounds selected from the group consisting of monoethanolamine, ethylethanolamine, diethanolamine and ammonia, and water, wherein the polishing agent has a pH of from 10 to 13 and wherein the basic compound is contained in an amount of more than 0.01 mass%.

## Description

### TECHNICAL FIELD

The present invention relates to a polishing technique used in a production step of a semiconductor integrated circuit device. More specifically, the present invention relates to a polishing agent suitable for planarizing a to-be-polished surface containing a borophosphosilicate glass material layer (hereinafter, sometimes referred to as a "BPSG layer") used in a semiconductor integrated circuit device, and a polishing technique for a BPSG layer-containing to-be-polished surface, used in a production step of a semiconductor integrated circuit device.

### BACKGROUND ART

With recent progress toward higher integration and higher functionality of a semiconductor integrated circuit device, development of a microfabrication technology for realizing refinement and high density is demanded. In particular, the importance of a planarizing technique by a chemical mechanical polishing method (hereinafter referred to as "CMP") has been rising.

For example, there is a problem that as the refinement of a semiconductor integrated circuit device or multi-layering of wiring advances, convexoconcave (difference in level) on the surface of each layer in the production step becomes great resulting from stacking of layers and exceeds the focal depth of the photolithography, thereby failing to obtain sufficiently high resolution. For solving such a problem due to difference in level, the CMP is an indispensable technique. Specifically, the CMP is used, for example, for the planarization of an inter-level insulation film (inter-level dielectrics; ILD film), shallow trench isolation (STI), formation of a tungsten plug or in the step of forming a multilayer wiring comprising copper and a low-dielectric film. Also, in recent years, this technique has come to be applied to planarization of an insulation film before a metal wiring formation (pre-metal dielectrics; PMD), for which a reflow method by a heat treatment had heretofore been used. A BPSG layer is used in these cases or used for a capacitor, a gate electrode and others in multilayer wiring, and CMP is employed for planarizing a to-be-polished surface containing a BPSG layer.

Conventionally, in the production step of a semiconductor integrated circuit device, when planarization of the to-be-polished surface containing a BPSG layer is performed, a silicon dioxide film or silicon nitride film is generally formed as a stopper layer under the BPSG layer that is the polishing object. By making high the ratio between the polishing rate of the BPSG layer and the polishing rate of the silicon dioxide film or silicon nitride film (hereinafter, (polishing rate of A)/(polishing rate of B) is sometimes referred to as "a polishing rate ratio of A and B") so that planarization of the to-be-polished surface can be realized when the stopper layer is exposed.

However, there is a problem that when an attempt is made to control the polishing rate of the BPSG layer, the polishing rate of the silicon nitride film or silicon dioxide film also changes.

- Patent Document 1:: JP-A-11-12561
- Patent document 2:: JP-A-2001-35818

### DISCLOSURE OF THE INVENTION

### PROBLEMS THAT THE INVENTION IS TO SOLVE

An object of the present invention is to solve the foregoing problems and provide a polishing agent for chemical mechanical polishing for polishing a to-be-polished surface in the production of a semiconductor integrated circuit device, which is a polishing agent suitable in the case where the to-be-polished surface contains a to-be-polished surface of a BPSG layer. Other objects and advantages of the present invention will become apparent from the following description.

### MEANS FOR SOLVING THE PROBLEMS

That is, the gist of the present invention resides in the following characteristics.

According to a first embodiment of the present invention, a polishing agent is provided, which is a polishing agent for chemical mechanical polishing for polishing a to-be-polished surface in the production of a semiconductor integrated circuit device, the polishing agent comprising a cerium oxide particle, a water-soluble polyamine, one or more basic compounds selected from the group consisting of monoethanolamine, ethylethanolamine, diethanolamine and ammonia, and water, wherein the polishing agent has a pH of from 10 to 13, and wherein the basic compound is contained in an amount of more than 0.01 mass% based on the entire mass of the polishing agent.

According to a second embodiment of the present invention, the polishing agent as described in embodiment 1 is provided, wherein the water-soluble polyamine is a water-soluble polyether polyamine having a weight average molecular weight of 100 to 2,000.

According to a third embodiment of the present invention, the polishing agent as described in embodiment 1 or 2 is provided, wherein the water-soluble polyamine is contained in an amount of 0.001 to 20 mass% based on the entire mass of the polishing agent.

According to a fourth embodiment of the present invention, the polishing agent as described in any one of embodiments 1 to 3 is provided, wherein the basic compound is contained in an amount of 0.01 to 2.0 mass% based on the entire mass of the polishing agent.

According to a fifth embodiment of the present invention, the polishing agent as described in any one of embodiments 1 to 4 is provided, wherein the cerium oxide particle is contained in an amount of 0.1 to 5.0 mass% based on the entire mass of the polishing agent.

According to a sixth embodiment of the present invention, a polishing method of a to-be-polished surface is provided, which comprises supplying a polishing agent to a polishing pad, bringing the to-be-polished surface of a semiconductor integrated circuit device into contact with the polishing pad, and performing polishing by means of relative movement between two members, wherein the to-be-polished surface contains a to-be-polished surface of a borophosphosilicate glass material layer and wherein the polishing agent described in any one of embodiments 1 to 5 is used as the polishing agent.

According to a seventh embodiment of the present invention, the polishing method as described in embodiment 6 is provided, wherein the semiconductor integrated circuit device has a silicon dioxide film or silicon nitride film directly below the borophosphosilicate glass material layer.

According to an eighth embodiment of the present invention, the polishing method as described in embodiment 6 or 7 is provided, wherein the semiconductor integrated circuit device has a silicon dioxide film directly below the borophosphosilicate glass material layer and a silicon nitride film directly below the silicon dioxide film, or has a silicon nitride film directly below the borophosphosilicate glass material layer and a silicon dioxide film directly below the silicon nitride film.

According to a ninth embodiment of the present invention, a method for producing a semiconductor integrated circuit device is provided, comprising a step of polishing a to-be-polished surface by the polishing method described in any one of embodiments 6 to 8.

### ADVANTAGE OF THE INVENTION

According to the present invention, when polishing a to-be-polished surface in the production of a semiconductor integrated circuit device, an appropriate polishing rate ratio between the BPSG layer and other materials can be obtained and high planarization of the to-be-polished surface can be thereby realized.

### BRIEF DESCRIPTION OF THE DRAWINGS

Figs. 1 are schematic cross-sectional views when a semiconductor device substrate is polished by the polishing agent of the present invention in the step of planarizing a to-be-polished surface containing a BPSG layer.
Fig. 2 is a view showing one example of the polishing apparatus applicable to the polishing method of the present invention.
Fig. 3 is a graph showing the relationship between the concentration of ammonia contained in the polishing agent and Vps, Vsn and Vso with respect to Examples 1 to 3 of the present invention.
Figs. 4 are schematic cross-sectional views when a semiconductor device substrate is polished by the polishing agent of the present invention in the step of planarizing a to-be-polished surface containing a BPSG layer.

### DESCRIPTION OF REFERENCE NUMERALS AND SIGNS

- 1: Silicon substrate
- 2: Silicon dioxide film
- 3: BPSG Layer
- 4: Silicon nitride film
- 5: To-be-polished surface after polishing
- 31: Semiconductor device
- 32: Polishing head
- 33: Polishing platen
- 34: Polishing pad
- 35: Polishing agent supply piping
- 36: Polishing agent

### BEST MODE FOR CARRYING OUT THE INVENTION

The embodiments of the present invention are described below by using drawings, tables, working examples and the like. Incidentally, description of these drawings, tables and working examples are only for illustrating the present invention and should not be construed as limiting the scope of the present invention. As long as the purport of the present invention is observed, other embodiments may belong to the category of the present invention. In the figures, identical numerals indicate identical elements.

The polishing agent of the present invention is a polishing agent for chemical mechanical polishing for polishing a to-be-polished surface of a semiconductor integrated circuit device (hereinafter, sometimes simply referred to as a "semiconductor device"), where the to-be-polished surface contains a to-be-polished surface of a BPSG layer, and the polishing agent contains a cerium oxide particle, a water-soluble polyamine, one or more basic compounds selected from the group consisting of monoethanolamine, ethylethanolamine, diethanolamine and ammonia, and water and wherein the pH of the polishing agent is from 10 to 13 and the basic compound is contained in an amount of more than 0.01 mass% based on the entire mass of the polishing agent. A dispersant may be allowed to coexist.

In the production step of a semiconductor device, in the case where the to-be-polished surface of the semiconductor device contains a to-be-polished surface of a BPSG layer, use of the polishing agent of the present invention enables easy control of the polishing rate ratio between the polishing rate of the BPSG layer and the polishing rate of the material other than BPSG layer. Therefore, when the to-be-polished surface of the BPSG layer is polished and the layer composed of other materials is exposed, a flat to-be-polished surface can be easily formed. Two or more BPSG layers may be contained in one semiconductor device. Incidentally, the "to-be-polished surface" as used in the present invention means a surface in an intermediate stage, appearing in the course of producing a semiconductor device.

The polishing agent of the present invention is useful when the semiconductor device has a silicon dioxide film or silicon nitride film directly below the BPSG layer. Such a construction is often employed in using a silicon dioxide film or silicon nitride film as a stopper film.

The polishing agent of the present invention is useful also when the semiconductor device has a silicon dioxide film directly below the BPSG layer and a silicon nitride film directly below the silicon dioxide film. Such a construction is often employed in the case of using a silicon nitride film as a stopper film and having thereon a silicon dioxide film and a BPSG layer. Of course, the polishing agent is useful also when the semiconductor device has a silicon nitride film directly below the BPSG layer and a silicon dioxide film directly below the silicon nitride film.

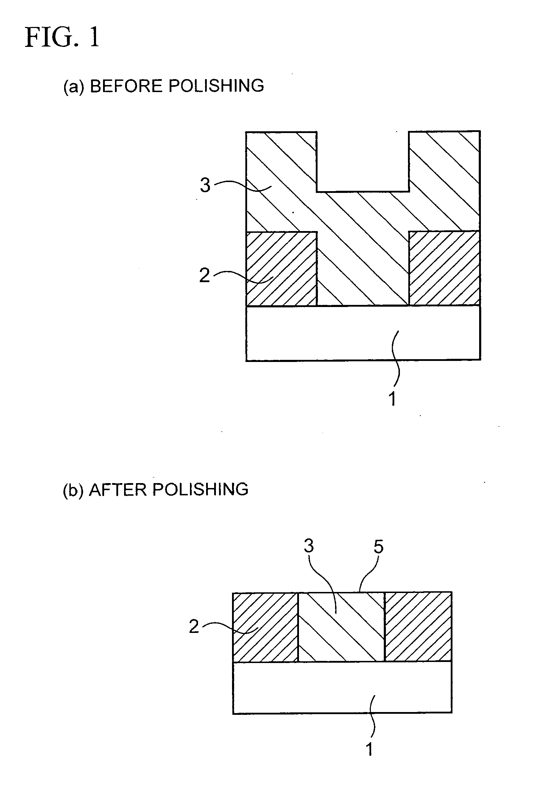

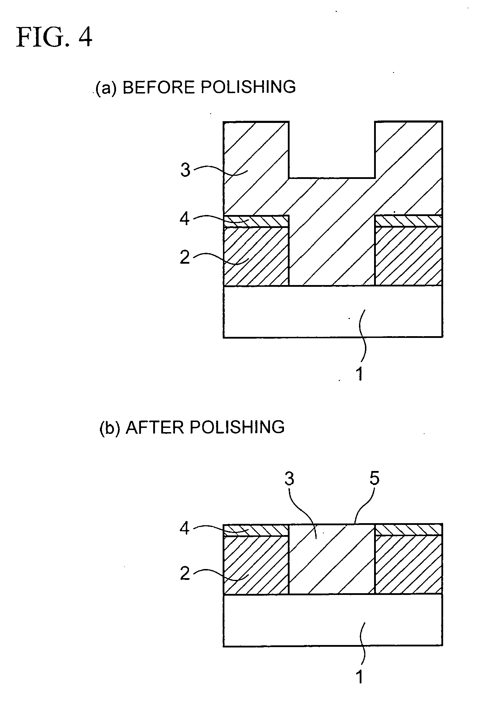

In Figs. 1 and 4, such states are shown. Figs. 1 and 4 are schematic transverse cross-sectional views of a semiconductor device where a silicon dioxide film 2, a BPSG layer 3 and a silicon nitride film 4 are stacked on a substrate 1.

As shown in Fig. 1 (a), when the semiconductor device has a construction of using a silicon dioxide film 2 as a stopper layer, the ratio between the polishing rate (Vps) of the BPSG layer 3 and the polishing rate (Vso) of the silicon dioxide film 2 (i.e., the polishing rate ratio Vps/Vso) can be made large by using the polishing agent of the present invention, whereby as shown in Fig. 1(b), upon exposure of the silicon dioxide film 2, the convexoconcave of the to-be-polished surface 5 can be highly planarized.

As shown in Fig. 4(a), when the semiconductor device has a construction of using a silicon nitride film 4 as a stopper layer, the ratio between the polishing rate (Vps) of the BPSG layer 3 and the polishing rate (Vsn) of the silicon nitride film 4 (i.e., the polishing rate ratio Vps/Vsn) can be made large by using the polishing agent of the present invention, whereby as shown in Fig. 4(b), upon exposure of the silicon nitride film 4, the convexoconcave of the to-be-polished surface 5 can be highly planarized.

Incidentally, the polishing agent of the present invention is free of aggregation of abrasive grains and therefore, is not only excellent in the dispersion stability but also advantageous against polishing defects.

In the present invention, cerium oxide is used as the polishing abrasive grain in the polishing agent. In an alkaline aqueous medium, a negatively charged silanol group is formed on the BPSG layer surface, so that the polishing agent of the present invention using a cerium oxide abrasive grain in place of a silica abrasive grain that is conventionally used as the polishing abrasive grain has a high polishing function on the BPSG layer through a chemical reaction. Accordingly, the polishing agent of the present invention exhibits a high polishing rate also for the BPSG layer, similarly to the silicon dioxide film. As for the cerium oxide abrasive grain for use in the present invention, a cerium oxide abrasive grain disclosed, for example, in Patent Document 1 or 2 may be suitably used. That is, a cerium oxide powder obtained by adding an alkali to an aqueous ammonium cerium(IV) nitrate solution to produce a cerium hydroxide gel and subjecting the gel to filtration, washing and firing can be preferably used. Furthermore, a cerium oxide abrasive grain obtained by grinding high-purity cerium carbonate, followed by firing, pulverization and classification may also be preferably used, but the present invention is not particularly limited thereto.

From the aspects of polishing properties and dispersion stability, the average particle size (diameter) of the cerium oxide abrasive grain is preferably from 0.01 to 0.5 µm, more preferably from 0.02 to 0.3 µm, still more preferably from 0.05 to 0.2 µm. If the average particle diameter is excessively large, there is a concern that polishing flaws such as scratch may be readily generated on the semiconductor substrate surface, whereas if the average particle diameter is too small, there is a concern that the polishing rate may decrease. Also, if the average particle diameter is too small, the proportion of the surface area per unit volume becomes large, and the abrasive grain is likely to be affected by the surface state. Therefore, depending on the conditions such as pH or additive concentration, there are cases where abrasive grains readily aggregate. When aggregation is caused, polishing flaws such as scratch are liable to be generated on the semiconductor substrate surface.

The cerium oxide particle for use in the present invention is preferably contained in an amount of 0.1 to 5.0 mass% based on the entire mass of the polishing agent. If the amount is less than 0.1 mass%, a sufficiently high polishing rate may not be obtained, whereas if it exceeds 5.0 mass%, it becomes often the case that the polishing agent comes to have an increased viscosity and the handling thereof becomes difficult.

The water-soluble polyamine in the polishing agent may be any compound as long as it is a water-soluble compound having two or more amino groups within one molecule. The water solubility may be in any level as long as the compound is completely dissolved in the polishing agent solution at the concentration on use as a polishing agent. Usually, a compound that is dissolved in pure water to a concentration of 1 mass% or more, preferably 5 mass% or more, is called "water-soluble". Specifically, one or more materials selected from the group consisting of a water-soluble polyether polyamine, a water-soluble polyalkylene polyamine, a polyethyleneimine, a water-soluble polyvinylamine, a water-soluble polylysine and a water-soluble chitosan are preferred. Particularly preferred water-soluble polyamines are a water-soluble polyether polyamine and a water-soluble polyalkylene polyamine.

The molecular weight of the water-soluble polyamine is not particularly limited as long as it is a molecular weight within the range having water solubility, but the molecular weight is preferably from 100 to 100,000, more preferably from 100 to 2,000, in terms of weight average molecular weight. If the weight average molecular weight is less than 100, the effect is small. If it exceeds 100,000, there may be adverse effect on the physical properties of the polishing agent, such as fluidity, even if it may be water-soluble. If the weight average molecular weight exceeds 2,000, solubility in water decreases in many cases. Above all, the water-soluble polyamine is preferably a water-soluble polyether polyamine or water-soluble polyalkylene polyamine, each having a weight average molecular weight of 100 to 2,000.

The water-soluble polyamine is used as an additive for suppressing the polishing rate of a silicon dioxide film and a silicon nitride film and controlling the polishing rate of the BPSG layer. Furthermore, by virtue of adding the above-described basic compound such as ammonia, the ratios (Vps/Vsn and Vps/Vso) of the polishing rate of the BPSG layer relative to the polishing rate (Vsn) of the silicon nitride film and the polishing rate (Vso) of the silicon dioxide film can be controlled.

When the water-soluble polyamine is added, the polishing rates of the silicon dioxide film and the silicon nitride film can be suppressed. This is considered to be attributable to an adsorption effect of the water-soluble polyamine (for example, polyoxypropylene diamine) to the cerium oxide abrasive grain surface and the to-be-polished surface. It is presumed that by this effect, the cerium oxide may be inhibited from contacting with the silicon dioxide film or silicon nitride film in the to-be-polished material and the progress of polishing may be thereby suppressed. Also, if the water-soluble polyamine is added, a convex part is preferentially polished while the progress of polishing of a concave part is suppressed, during polishing of the BPSG layer. As a result, high planarization can be attained. This is considered to be attributable to an adsorption effect of the water-soluble polyamine to the cerium oxide abrasive grain surface and the to-be-polished surface. Specifically, it is considered that in the concave part where the polishing pressure is low, the chemical reaction due to contact of cerium oxide with the Si-O moiety of the BPSG layer is inhibited, but in the convex part where the polishing pressure is high, the adsorbed water-soluble polyamine readily falls off and the polishing preferentially proceeds.

The water-soluble polyamine particularly preferred in the present invention is one or more water-soluble polyamines selected from the group consisting of a water-soluble polyether polyamine having a weight average molecular weight of 100 to 2,000 and a water-soluble polyalkylene polyamine having a weight average molecular weight of 100 to 2,000. In view of high dispersion stabilizing effect on the cerium oxide abrasive grain, the weight average molecular weight of this water-soluble polyether polyamine is more preferably from 150 to 800, still more preferably from 150 to 400.

The polyether polyamine means a compound having two or more amino groups and two or more etheric oxygen atoms. The amino group is preferably a primary amino group (-NH₂). A secondary amino group (-NH-) or a tertiary amino group may be present, but the polyether polyamine for use in the present invention is preferably a compound having two or more primary amino groups and having substantially no other amino groups, more preferably a polyether diamine having only two or more primary amino groups. The polyether polyamine is preferably a compound having a structure where the hydrogen atom of the hydroxyl group in a polyhydric alcohol or polyether polyol is replaced by an aminoalkyl group. The polyhydric alcohol is preferably a di- to hexa-hydric alcohol, more preferably a dihydric alcohol, and the polyether polyol is preferably a di- to hexa-valent polyoxyalkylene polyol, more preferably a polyoxyalkylene diol. The aminoalkyl group is preferably an aminoalkyl group having from 2 to 6 carbon atoms, such as 2-aminoethyl group, 2-aminopropyl group, 2-amino-1-methylethyl group, 3-aminopropyl group, 2-amino-1,1-dimethylethyl group and 4-aminobutyl group.

The polyhydric alcohol is preferably a dihydric alcohol having from 2 to 8 carbon atoms, which may have an etheric oxygen atom, such as ethylene glycol, diethylene glycol, propylene glycol, and dipropylene glycol. The polyether polyol is preferably a polyether diol with the repeating unit being an oxyalkylene group having from 2 to 6 carbon atoms, for example, a polyethylene glycol (i.e., polyoxyethylene diol) such as triethylene glycol and tetraethylene glycol, a polypropylene glycol (i.e., polyoxypropylene diol) such as tripropylene glycol and tetrapropylene glycol, or a polyoxyalkylene diol having two or more oxyalkylene groups, such as poly(oxypropylene-oxyethylene)diol.

The polyalkylene polyamine means a compound in which three or more amino groups are bonded through an alkylene group. It is preferred that the terminal amino group is a primary amino group and the amino group within the molecule is a secondary amino group. A chain polyalkylene polyamine having a primary amino group at two molecular terminals and one or more secondary amino groups within the molecule is more preferred. Two or more linking moieties each interposed between an amino group and another amino group and composed of an alkylene group are present within one molecule. Such a plurality of amino group-to-amino group linking moieties may be the same or different from one another, and it is preferred that all are the same, or that two amino group-to-amino group linking moieties that bond to the primary amino group at both terminals are the same and differ from other amino group-to-amino group linking moieties. The number of carbon atoms contained in one amino group-to-amino group linking moiety is preferably 2 to 8. In particular, the number of carbon atoms contained in each of two amino group-to-amino group linking moieties that bond to the primary amino group at both terminals is preferably from 2 to 8 and the number of carbon atoms contained in each of other amino group-to-amino group linking moieties is preferably from 2 to 6.

The polyether diamine and polyalkylene polyamine are preferably a compound having a structure represented by the following formula (1):

H₂N-(R-X-)ₖ-R-NH₂ (1)

wherein R represents an alkylene group having from 2 to 8 carbon atoms, X represents an oxygen atom or -NH-, and k represents an integer of 2 or more in the case of a polyether diamine and an integer of 1 or more in the case of a polyalkylene polyamine. The plurality of R's within one molecule may be different from one another.

In particular, the polyether diamine is preferably a compound having a structure represented by the following formula (2), and the polyalkylene polyamine is preferably a compound having a structure represented by the following formula (3):

H₂N-R²-O-(R¹-O-)ₘ-R²-NH₂ (2)

H₂N-R⁴-NH-(R³-NH-)ₙ-R⁴-NH₂ (3)

wherein R¹ represents an ethylene group or a propylene group, R² represents an alkylene group having from 2 to 6 carbon atoms, R³ represents an alkylene group having from 2 to 6 carbon atoms, R⁴ represents an alkylene group having from 2 to 8 carbon atoms, m represents an integer of 1 or more, n represents an integer of 1 or more, R¹ and R² may be the same or different, and R³ and R⁴ may be the same or different.

Specific examples of the polyether diamine represented by formula (2) include a polyoxypropylene diamine (a compound where R¹ and R² are a propylene group and m is an integer of 1 or more), a polyoxyethylene diamine (a compound where R¹ and R² are an ethylene group and m is an integer of 1 or more), a 4,7,10-trioxa-tridecane-1,13-diamine (a compound where R¹ is an ethylene group, R² is a trimethylene group and m is an integer of 2). Specific examples of the polyalkylene polyamine represented by formula (3) include tetraethylenepentamine (a compound where R³ and R⁴ are an ethylene group and n is 2), pentaethylenehexamine (a compound where R³ and R⁴ are an ethylene group and n is 3), heptaethyleneoctamine (a compound where R³ and R⁴ are an ethylene group and n is 5), N,N'-bis(3-aminopropyl)-ethylenediamine (a compound where R³ is an ethylene group, R⁴ is a trimethylene group and n is 1), and N,N'-bis(2-aminoethyl)-1,4-butanediamine (a compound where R³ is a tetramethylene group, R⁴ is an ethylene group and n is 1).

From the standpoint of obtaining a sufficiently high effect of suppressing the polishing rate, the concentration of the water-soluble polyamine in the polishing agent is from 0.001 to 20 mass%, and an appropriate concentration is preferably selected by taking into consideration the polishing rate, the uniformity of the polishing agent slurry, the weight average molecular weight of the water-soluble polyamine, and the like. The concentration of the water-soluble polyamine in the polishing agent is more preferably from 0.05 to 5 mass%.

Water for use in the present invention is not particularly limited, but pure water, ultrapure water, ion-exchanged water and the like may be preferably used in view of effect on other agents, incorporation of impurities and effect, for example, on pH.

The polishing agent of the present invention can be used in an alkaline pH region. Considering the polishing properties and dispersion stability of the polishing agent, the pH is preferably from 10 to 13. If the pH is less than 10, there is a concern that dispersibility may decrease, whereas if it exceeds 13, this is not problematic in terms of polishing properties but there is a concern that the to-be-polished surface may be affected. Also, there is a concern that the operability (handleability) may be deteriorated.

The polishing agent of the present invention contains one or more basic compounds selected from the group consisting of monoethanolamine, ethylethanolamine, diethanolamine and ammonia. Above all, ammonia is preferred because the polishing rate can be easily controlled. The basic compound includes those added for other purposes, such as dispersant for the abrasive grain. The ammonia includes those in the form of ammonium, such as ammonium polyacrylate which is a dispersant for the abrasive grain.

The polishing rate of the BPSG layer can be controlled by changing the kind of the basic compound and the addition amount thereof.

In the polishing agent of the present invention, the basic compound is added, whereby the BPSG layer can be polished at a high rate while the ratios of the polishing rate of the BPSG layer to the polishing rate of the silicon nitride film (Vsn) and the polishing rate of the silicon dioxide film (Vso), i.e., both Vps/Vsn and Vps/Vso, are kept as large as 10 or more.

The basic compound needs to be contained in an amount of more than 0.01 mass% based on the entire mass of the polishing agent. A content lower than this range is insufficient for controlling the polishing rate. The basic compound is preferably contained in an amount of 0.01 to 2.0 mass% based on the entire mass of the polishing agent. If the content is less than 0.01 mass%, the effect of controlling the polishing rate of the BPSG layer is small, whereas even if it exceeds 2.0 mass%, there is not obtained any particular additional effect.

In the polishing agent of the present invention, other components may be allowed to coexist. The representative component includes a dispersant. The dispersant is preferably a water-soluble surfactant or a water-soluble polymer. The surfactant may be anionic, cationic or nonionic. A polymer having a carboxylic acid group, an ammonium carboxylate or the like is preferred. Examples thereof include a polyacrylic acid and a salt thereof such as ammonium polyacrylate.

The polishing agent of the present invention supplied to the polishing site need not be necessarily in the form that all the polishing materials constituting the polishing agent are previously mixed. Polishing materials may be mixed at the time of supplying the polishing agent to the polishing site to complete the composition of the polishing agent. For example, the polishing agent composition may be divided into a solution containing a cerium oxide particle, water and optionally a dispersant, and a solution containing a water-soluble polyamine and the basic compound above, and these solutions may be used with appropriately adjusting the mixing ratio at the time of polishing. Also, the polishing agent composition may be divided into a solution containing a cerium oxide particle, a dispersant, a water-soluble polyamine and water, and a solution containing a basic compound and water. Other dividing ways may also be employed.

In the case of polishing a semiconductor substrate by using the polishing agent of the present invention, the polishing agent is supplied to a polishing pad, the to-be-polished surface of a semiconductor device is brought into contact with the polishing pad, and the to-be-polished surface containing the to-be-polished surface of a BPSG layer is polished by means of relative movement between the two members. As already described, when the polishing agent of the present invention is used, the polishing rate ratio between the BPSG layer and the silicon dioxide film or between the BPSG layer and the silicon nitride film can be made large and therefore, the polishing method of the present invention can be suitably used particularly when the semiconductor device has a silicon dioxide film or silicon nitride film directly below the BPSG layer or when the semiconductor device has a silicon dioxide film directly below the BPSG layer and a silicon nitride film directly below the silicon dioxide film. Of course, the method can be suitably used also when the semiconductor device has a silicon nitride film directly below the BPSG layer and a silicon dioxide film directly below the silicon nitride film.

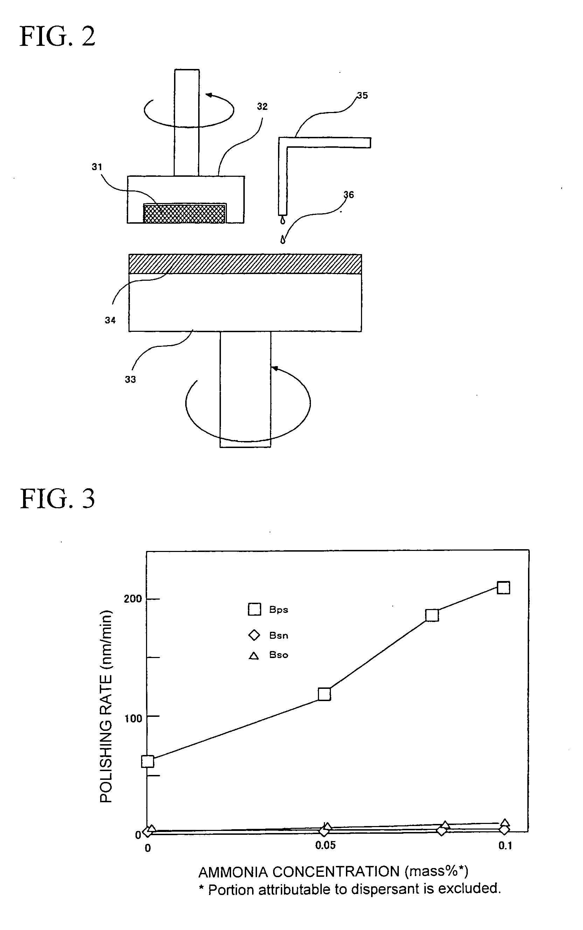

As for the polishing apparatus, a general polishing apparatus can be used. Fig. 2 shows one example of the polishing apparatus applicable to the polishing method of the present invention. This is a system in which while supplying a polishing agent 36 from a polishing agent supply piping 35, a semiconductor device 31 is held on a polishing head 32 and brought into contact with a polishing pad 34 attached to the surface of a polishing platen 33, and at the same time, the polishing head 32 and the polishing platen 33 are rotated to make a relative movement. However, the polishing apparatus for use in the present invention is not limited thereto.

The polishing head 32 may not only rotate but also linearly move. The polishing platen 33 and the polishing pad 34 each may have a size equal to or smaller than the size of the semiconductor device 31. In this case, it is preferred that the polishing head 32 and the polishing platen 33 are moved relatively so that the entire surface of the semiconductor device can be polished. Also, the polishing platen 33 and the polishing pad 34 may not employ a rotary system but each may be moved in one direction, for example, by a belt system.

The polishing conditions of the polishing apparatus are not particularly limited, but the polishing rate can be increased by pressing the polishing head 32 against the polishing pad 34 while applying a load. At this time, the polishing pressure is preferably about 0.5 to 50 kPa and, in view of uniformity of the polishing rate in the semiconductor device, planarity and prevention of polishing defect such as scratch, more preferably about 3 to 40 kPa. The rotation frequencies of the polishing platen and polishing head are preferably about 50 to 500 rpm, but are not limited thereto.

As for the polishing pad, a general polishing pad formed of non-woven fabric, foamed polyurethane, porous resin, non-porous resin or the like may be used. Also, a grooving work, for example, in a grid, concentric or spiral form may be made on the surface of the polishing pad so as to accelerate the supply of the polishing agent or to allow a given amount of the polishing agent to stay.

In this way, according to the present invention, when polishing the to-be-polished surface in the production of a semiconductor device, a high polishing rate can be attained for the BPSG layer and at the same time, appropriate polishing rate ratios can be established between the BPSG layer and other materials. Accordingly, in the production of a semiconductor device using the polishing method of the present invention, the cost can be reduced and the throughput can be improved.

### EXAMPLES

Examples of the present invention will be illustrated below. Examples 1 to 4 are Invention Examples and Examples 5 to 8 are Comparative Examples. In Examples, unless otherwise indicated, "%" means "mass%". The characteristic values were evaluated by the following methods.

### (pH)

The pH was measured by pH81-11 manufactured by Yokogawa Electric Corporation.

### (Average Particle Diameter of Abrasive Grain)

The average particle diameter was determined by a laser scattering·diffraction apparatus (LA-920, trade name, manufactured by Horiba, Ltd.).

### (Dispersion Stability of Polishing Agent)

The "coagulation sedimentation time" in Examples was determined as the time from placing 20 mL of the polishing agent into a glass-made test tube of 18 mm in diameter and standing for 2 days until separation into two layers occurred to produce a supernatant.

### (Polishing Properties)

### (1) Polishing Conditions

The polishing was performed using the following apparatus and conditions.
Polishing machine: full-automatic CMP apparatus MIRRA (manufactured by APPLIED MATERIALS)
Polishing agent supply rate: 200 ml/min
Polishing pad: 2-layer pad IC-1400, K-groove
Conditioning of polishing pad: MEC100-PH3.5L (manufactured by Mitsubishi Materials Corp.)
Rotation frequency of polishing platen: 77 rpm (common in all Examples)
Rotation frequency of Polishing head: 73 rpm (common in all Examples)
Polishing pressure: 27.6 kPa (common in all Examples)

### (2) Material to be Polished

As for the material to be polished, a 8-inch silicon wafer substrate having formed thereon a BPSG layer by the CVD method, a 8-inch silicon wafer substrate having formed thereon a silicon nitride film by the CVD method, and a 8-inch silicon wafer substrate having formed thereon a silicon dioxide film by the HDP (high-density plasma CVD) method were used.

### (3) Characteristic Evaluation Method of Polishing Agent

Measurement of polishing rate: film thickness meter UV-1280SE (manufactured by KLA-Tencor) was used.

### [Example 1]

A cerium oxide abrasive grain and ammonium polyacrylate having a molecular weight of 5,000 as a dispersant were mixed in deionized water with stirring to give a mass ratio of 100:0.7, and the mixture was subjected to ultrasonic dispersion and filtration to obtain a mixture having an abrasive grain concentration of 10% and a dispersant concentration of 0.07%. This mixture was 5-fold diluted with deionized water to produce Abrasive Grain Mixture A having an abrasive grain concentration of 2.0% and a dispersant concentration of 0.014%. The pH of Abrasive Grain Mixture A was 7.6 and the average particle diameter was 0.19 µm.

Subsequently, as additives, polyoxypropylene diamine having a molecular weight of 230 (Polyether-Amine, trade name, produced by BASF), which is an amine-based water-soluble polymer, and ammonia which is a basic compound, were dissolved in deionized water to produce Additive Solution B 1 having a polyoxypropylene diamine concentration of 2.0% and an ammonia concentration of 0.1 %.

Additive Solution B1 and Abrasive Grain Mixture A were mixed with stirring in a mass ratio of 1:1 to produce a polishing agent having an abrasive grain concentration of 1.0%, a concentration of ammonium polyacrylate as a dispersant of 0.007%, a polyoxypropylene diamine concentration of 1.0%, an ammonia concentration of 0.05%, and a pH of 10.9.

The composition of the polishing agent and the evaluation results of polishing properties are shown in Table 1.

### [Example 2]

Abrasive Grain Mixture A was produced in the same manner as in Example 1, and Additive Solution B2 was produced in the same manner as in Example 1 except that in the preparation of Additive Solution B1, the ammonia concentration was adjusted to 0.16%. Additive Solution B2 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, an ammonia concentration of 0.08%, and a pH of 10.9.

The polishing agent produced was evaluated in the same manner as in Example 1. The composition of the polishing agent and the evaluation results of polishing properties are shown in Table 1.

### [Example 3]

Abrasive Grain Mixture A was produced in the same manner as in Example 1, and Additive Solution B3 was produced in the same manner as in Example 1 except that in the preparation of Additive Solution B1, the ammonia concentration was adjusted to 0.2%. Additive Solution B2 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, an ammonia concentration of 0.1%, and a pH of 10.9.

The polishing agent produced was evaluated in the same manner as in Example 1. The composition of the polishing agent and the evaluation results of polishing properties are shown in Table 1.

### [Example 4]

Abrasive Grain Mixture A was produced in the same manner as in Example 1, and Additive Solution B4 was produced in the same manner as in Example 1 except that in the preparation of Additive Solution B1, monomethanolamine was used in a concentration of 0.72% in place of ammonia. Additive Solution B4 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, a monomethanolamine concentration of 0.36%, and a pH of 11.0.

The polishing agent produced was evaluated in the same manner as in Example 1. The composition of the polishing agent and the evaluation results of polishing properties are shown in Table 1.

### [Example 5]

Abrasive Grain Mixture A was produced in the same manner as in Example 1, and Additive Solution B5 was produced in the same manner as in Example 1 except that in the preparation of Additive Solution B1, ammonia was not used. Additive Solution B5 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, and a pH of 10.7.

The polishing agent produced was evaluated in the same manner as in Example 1. The composition of the polishing agent and the evaluation results of polishing properties are shown in Table 1.

### [Example 6]

Abrasive Grain Mixture A was produced in the same manner as in Example 1, and Additive Solution B6 was produced in the same manner as in Example 1 except that in the preparation of Additive Solution B1, potassium hydroxide was used in a concentration of 0.06% in place of ammonia. Additive Solution B6 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, a potassium hydroxide concentration of 0.03%, and a pH of 11.4.

The polishing agent produced was evaluated in the same manner as in Example 1. The composition of the polishing agent and the evaluation results of polishing properties are shown in Table 1.

### [Example 7]

Abrasive Grain Mixture A was produced in the same manner as in Example 1, and Additive Solution B7 was produced in the same manner as in Example 1 except that in the preparation of Additive Solution B1, trishydroxymethylaminomethane was used in a concentration of 1.42% in place of ammonia. Additive Solution B7 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, a trishydroxymethylaminomethane concentration of 0.71%, and a pH of 10.8.

The polishing agent produced was evaluated in the same manner as in Example 1. The composition of the polishing agent and the evaluation results of polishing properties are shown in Table 1.

### [Example 8]

Abrasive Grain Mixture A was produced in the same manner as in Example 1, and Additive Solution B8 was produced in the same manner as in Example 1 except that in the preparation of Additive Solution B1, ammonium sulfate was used in a concentration of 1.56% in place of ammonia. Additive Solution B8 and Abrasive Grain Mixture A were mixed in a mass ratio of 1:1 to produce a polishing agent having an abrasive grain concentration of 1.0%, a concentration of ammonium polyacrylate as a dispersant of 0.007%, a concentration of polyoxypropylene diamine as an additive of 1.0%, an ammonium sulfate concentration of 0.78%, and a pH of 9.2.

The polishing agent produced was evaluated in the same manner as in Example 1. The composition of the polishing agent and the evaluation results of polishing properties are shown in Table 1.

Incidentally, the polishing agents when produced by the methods described in Examples 1 to 7 each had an average particle diameter of 0.19 µm, similarly to Abrasive Grain Mixture A. That is, by the mixing with Additive Solutions B1 to B7, aggregation of abrasive grains did not proceed. The polishing agent was left standing and evaluated for the dispersion stability. As a result, the dispersion was maintained even with the lapse of two or more days. This dispersed state was on the same level as that of Abrasive Grain Mixture A to which the additive was not added, revealing that the dispersibility was very good. On the other hand, in Example 8 where the pH was less than 10, aggregation of abrasive grains was immediately generated.

**[Table 1]**

| | Composition, etc. (mass%) | | Basic Compound | | | Polishing Rate [nm/mm] | | | Polishing Rate Ratio [-] | | Coagulation Sedimentation Time |
|---|---|---|---|---|---|---|---|---|---|---|---|
| Example No. | Cerium Oxide | Polyetheramine | Kind | mass% | pH of Polishing agent | Vps | Vsn | Vso | Vps/Vsn | Vps/Vso | |
| 1 | 1.0 | 1.0 | ammonia | 0.05 | 10.9 | 118.9 | 2.2 | 7.2 | 54 | 16 | >2 days |
| 2 | 1.0 | 1.0 | ammonia | 0.08 | 10.9 | 185.5 | 2.3 | 8.5 | 81 | 22 | >2 days |
| 3 | 1.0 | 1.0 | ammonia | 0.10 | 10.9 | 209.1 | 2.4 | 8.8 | 87 | 24 | >2 days |
| 4 | 1.0 | 1.0 | monoethanolamine | 0.36 | 11.0 | 178.5 | 2.8 | 14.9 | 63 | 12 | >2 days |
| 5 | 1.0 | 1.0 | - | 0.00 | 10.7 | 61.4 | 2.2 | 6.3 | 28 | 10 | >2 days |
| 6 | 1.0 | 1.0 | potassium hydroxide | 0.03 | 11.4 | 684.0 | 13.1 | 323.6 | 52 | 2 | >2 days |
| 7 | 1.0 | 1.0 | trishydroxymethylaminomethane | 0.71 | 10.8 | 51.2 | 1.7 | 5.3 | 29 | 10 | >2 days |
| 8 | 1.0 | 1.0 | ammonium sulfate | 0.78 | 9.2 | 470.0 | 5.9 | 38.3 | 80 | 12 | 10 min |

The results of Table 1 are shown together in the graph of Fig. 3. As understood from this graph, in the case of the composition of the present invention, a large polishing rate of the BPSG layer can be attained while keeping small the polishing rate of the silicon dioxide film or silicon nitride film. That is, the polishing rate of the BPSG layer, Vps, and the polishing rate ratios, Vps/Vso and Vps/Vsn, can be made large.

Also, the polishing agent of the present invention can be suitably used in the case where a silicon dioxide film or a silicon nitride film is used as a stopper layer under the BPSG layer in the step of planarizing the to-be-polished surface containing the BPSG layer, and can widely control the polishing rate of the BPSG layer while keeping low the polishing rate of the silicon nitride film or silicon dioxide film. Furthermore, the polishing agent of the present invention is assured of no aggregation of abrasive grains and excellent dispersion stability and is advantageous also in terms of polishing defect.

While the present invention has been described in detail and with reference to specific embodiments thereof, it will be apparent to one skilled in the art that various changes and modifications can be made therein without departing from the spirit and scope of the invention.
This application is based on Japanese Patent Application No. 2006-245262 filed on September 11, 2006, the contents of which are incorporated herein by way of reference.

### INDUSTRIAL APPLICABILITY

The polishing agent of the present invention is excellent in the dispersion stability as well as in the planarization property of planarly polishing the to-be-polished surface containing a BPSG layer and produces less polishing defect. Therefore, the polishing agent is suitably applied to the production step of a semiconductor device, in particular, to the steps of planarizing a to-be-polished surface containing a BPSG layer used for a capacitor, a gate electrode and others in a multilayer wiring-forming step, planarizing an inter-level insulation film involving a BPSG layer, or planarizing an insulation film for shallow trench isolation.

## Claims

1. A polishing agent, which is a polishing agent for chemical mechanical polishing for polishing a to-be-polished surface in the production of a semiconductor integrated circuit device, said polishing agent comprising:
a cerium oxide particle,
a water-soluble polyamine,
one or more basic compounds selected from the group consisting of monoethanolamine, ethylethanolamine, diethanolamine and ammonia, and
water,
wherein said polishing agent has a pH of from 10 to 13, and
wherein said basic compound is contained in an amount of more than 0.01 mass% based on the entire mass of said polishing agent.

2. The polishing agent as claimed in claim 1, wherein said water-soluble polyamine is a water-soluble polyether polyamine having a weight average molecular weight of 100 to 2,000.

3. The polishing agent as claimed in claim 1 or 2, wherein said water-soluble polyamine is contained in an amount of 0.001 to 20 mass% based on the entire mass of said polishing agent.

4. The polishing agent as claimed in any one of claims 1 to 3, wherein said basic compound is contained in an amount of 0.01 to 2.0 mass% based on the entire mass of said polishing agent.

5. The polishing agent as claimed in any one of claims 1 to 4, wherein said cerium oxide particle is contained in an amount of 0.1 to 5.0 mass% based on the entire mass of said polishing agent.

6. A polishing method of a to-be-polished surface, comprising supplying a polishing agent to a polishing pad, bringing the to-be-polished surface of a semiconductor integrated circuit device into contact with the polishing pad, and performing polishing by means of relative movement between two members,
wherein said to-be-polished surface contains a to-be-polished surface of a borophosphosilicate glass material layer, and
wherein the polishing agent claimed in any one of claims 1 to 5 is used as said polishing agent.

7. The polishing method as claimed in claim 6, wherein said semiconductor integrated circuit device has a silicon dioxide film or silicon nitride film directly below said borophosphosilicate glass material layer.

8. The polishing method as claimed in claim 6 or 7, wherein said semiconductor integrated circuit device has a silicon dioxide film directly below said borophosphosilicate glass material layer and a silicon nitride film directly below said silicon dioxide film, or has a silicon nitride film directly below said borophosphosilicate glass material layer and a silicon dioxide film directly below said silicon nitride film.

9. A method for producing a semiconductor integrated circuit device, comprising a step of polishing a to-be-polished surface by the polishing method claimed in any one of claims 6 to 8.
